# EUROPÄISCHE PATENTSCHRIFT

(11) **EP 3 632 016 B1**
(45) Veröffentlichungstag und Bekanntmachung des Hinweises auf die Patenterteilung: **28.02.2024**
(21) Anmeldenummer: 18725823.1
(22) Anmeldetag: 17.05.2018
(51) Int. Cl.: H04L 1/00

(54) **EINGEBETTETE ZYKLISCHE REDUNDANZPRÜFUNGSWERTE**
EMBEDDED CYCLICAL REDUNDANCY CHECK VALUES
VALEURS DE VÉRIFICATION PAR REDONDANCE CYCLIQUES INTÉGRÉES

(30) Priorität: 24.05.2017 DE 102017208826
(43) Veröffentlichungstag der Anmeldung: 08.04.2020
(73) Patentinhaber: WAGO Verwaltungsgesellschaft mbH, 32423 Minden (DE)
(72) Erfinder: QUAKERNACK, Frank, 33615 Bielefeld (DE); JEROLM, Daniel, 49152 Bad Essen (DE)
(74) Vertreter: Bardehle Pagenberg Partnerschaft mbB Patentanwälte Rechtsanwälte
(86) Internationale Anmeldenummer: PCT/EP2018/062904
(87) Internationale Veröffentlichungsnummer: WO 2018/215285

(56) Entgegenhaltungen:
- WO-A1-2008/073494
- US-A1- 2010 192 048
- US-B1- 7 360 142
- LIN CUI ET AL: "Partial CRC Checksum of SCTP for Error Control over Wireless Networks", WIRELESS PERSONAL COMMUNICATIONS, KLUWER ACADEMIC PUBLISHERS, DO, Bd. 48, Nr. 2, 20. Juni 2008 (2008-06-20), Seiten 247-260, XP019650488, ISSN: 1572-834X

## Beschreibung

### 1. Gebiet der Erfindung

Die vorliegende Erfindung betrifft zyklische Redundanzprüfungswerte, CRC-Werte, und insbesondere in Datenpaketen eingebettete zyklische Redundanzprüfungswerte.

### 2. Stand der Technik

Eine zyklische Redundanzprüfung wird bei der Übertragung von Datenpaketen eingesetzt. Sie dient dazu Fehler bei der Übertragung der Datenpakete zu erkennen fehlerhafte Datenpakete auszusortieren oder gegebenenfalls zu korrigieren.

Dabei wird vor der Übertragung des Datenpaketes dem Datenpaket zusätzliche Redundanz in Form eines sogenannten Redundanzprüfungswertes oder auch kurz CRC-Wertes angefügt. Dieser CRC-Wert ist ein nach einem bestimmten Verfahren aus den Daten des Datenpaketes berechneter Prüfwert, mit dessen Hilfe man eventuelle während der Übertragung aufgetretene Fehler erkennen kann. Der CRC-Wert selbst besitzt keinen Informationsgehalt der über das hinausgeht, was bereits in dem zugrunde liegenden Datenpaket enthalten ist. Der CRC-Wert ist dementsprechend redundant.

Die Berechnungsverfahren zur Berechnung des CRC-Wertes beruhen auf zyklischen Codes. Das sind Block-Codes, die die Eigenschaft haben, dass jede zyklische Verschiebung der Bits eines gültigen Code-Worts ebenfalls ein gültiges Code-Wort ist. Mathematisch betrachtet beruht die Berechnung des CRC-Wertes auf dyadischen Polynomen in denen die Daten des Datenpaketes abgebildet werden. Dieses dyadische Polynom wird durch ein CRC-Generatorpolynom - auch als CRC-Polynom bezeichnet - geteilt und der Rest dieser Polynomdivision ergibt den CRC-Wert, der dem Datenpaket angehängt wird. Wird das Datenpaket mit CRC-Wert fehlerfrei übertragen und auf der Empfängerseite ebenfalls zur Überprüfung durch das CRC-Polynom geteilt, so ergibt sich ein Rest von Null. Ist ein Fehler bei der Übertragung aufgetreten, so ergibt sich ein von Null verschiedener Rest. Die zur Erzeugung und zur Überprüfung der des CRC-Wertes benötigte Polynomdivision lässt sich sehr einfach in Hardware durch die Verwendung von XOR-Gattern realisieren.

Jedes CRC-Polynom hat eine sogenannte "Hamming-Distanz". Diese gibt an, wie viele Daten maximal vorhanden sein dürfen, damit der aus den Daten erzeugte CRC-Wert eindeutig ist. Wenn mehr Daten mit dem CRC-Polynom zur Erzeugung des CRC-Wertes herangezogen werden als die "Hamming-Distanz" zulässt, kann es passieren, dass die Daten als gültig erkannt werden, obwohl sie fehlerhaft sind. Dies basiert darauf, dass in diesem Fall der CRC-Wert nicht mehr eindeutig ist.

Bei vielen Übertragungen werden daher feste Größen an Datenpaketen verwendet, wie zum Beispiel in US 7,360,142 B1 beschrieben, also Datenpakete mit einer bestimmten festgelegten Anzahl von Daten und es wird ein CRC-Polynom verwendet, welches eine "Hamming-Distanz" aufweist, die eben zu der Anzahl von Daten im Datenpaket passt, so dass ein eindeutiger CRC-Wert berechnet werden kann.

Wenn Datenpakete mit nicht fester Größe verwendet werden sollen, also Datenpakete bei denen die Anzahl der Daten nicht festgelegt ist, so wird zumeist ein CRC-Polynom verwendet, welches eine "Hamming-Distanz" aufweist, die für die maximale Anzahl an Daten eines Datenpaketes ausgelegt ist. Das CRC-Polynom wird also auch dann verwendet, wenn das Datenpaket nicht immer diese maximale Anzahl an Daten erreicht.

Bei derartigen Verfahren wird also nicht auf die unterschiedliche Anzahl von Daten in Datenpaketen reagiert. Entweder hat das ausgewählte CRC-Polynom eine zu geringe "Hamming-Distanz" für die Anzahl von Daten in einem Datenpaket oder es wird ständig ein unnötiger Mehraufwand erzeugt, durch ein CRC-Polynom mit unnötig großer "Hamming-Distanz". Dabei ist festzuhalten, dass je größer die "Hamming-Distanz" ist, desto größer ist der Rechenaufwand der benötigt wird, um den CRC-Wert zu berechnen und die Überprüfung durchzuführen beziehungsweise desto größer ist der Hardwareaufwand an XOR-Gattern.

Ausgehend hiervon ist es die Aufgabe der vorliegenden Erfindung eine Redundanzprüfung von Datenpaketen zu erlauben, wobei die Datenpakete eine variable Länge haben können.

### 3. Zusammenfassung der Erfindung

Diese Aufgabe wird mit einem Verfahren und einer Vorrichtung zur Bildung eines Datenpaketes mit zyklischen Redundanzprüfungswerten, CRC-Werten, gelöst sowie durch ein entsprechendes Verfahren und eine Vorrichtung zum Empfangen und Überprüfen eines derartigen Datenpaketes mit zyklischen Redundanzprüfungswerten.

Entsprechend des erfindungsgemäßen Verfahrens wird zumindest ein CRC-Wert in ein Datenpaket eingebettet, mit diesem eingebetteten CRC-Wert ist dann eine Überprüfung des Datenpaketes und dessen fehlerfreien Übertragung möglich. Je nach Anzahl der Daten in dem Datenpaket wird dabei zumindest einer oder mehrere CRC-Werte in das Datenpaket eingebettet beziehungsweise eingefügt.

Dabei weist das erfindungsgemäße Verfahren zur Bildung eines zu übertragenden Datenpaketes mit Daten und zumindest einem Wert zur zyklischen Redundanzprüfung auf, Initialisieren eines Zählerwertes, Abzählen von Einheiten von Daten, wobei für jede Einheit von Daten der Zählerwert geändert wird und Einfügen eines CRC-Wertes in die Daten, wenn der Zählerwert einen Referenzwert erreicht hat oder alle Einheiten von Daten in dem Datenpaket bereits abgezählt wurden, wobei der CRC-Wert über die Einheiten von Daten gebildet wird, die abgezählt wurden seit der Zähler das letzte Mal den Referenzwert erreicht hat oder seit der Zählerwert initialisiert wurde. Mit anderen Worten, das erfindungsgemäße Verfahren zählt Einheiten von Daten im Datenpaket ab, beispielsweise ist eine Einheit ein feste Anzahl von Bits. Diese feste Anzahl von Bits kann beispielsweise ein Byte sein. Wenn eine vorher bestimmte Menge an Einheiten abgezählt wurde, der Zählerwert also einen bestimmten Referenzwert erreicht hat, so wird ein CRC-Wert über die abgezählten Einheiten gebildet und in das Datenpaket eingefügt. Das Abzählen kann dabei darauf beruhen, dass der Zählerwert inkrementiert oder dekrementiert wird. Anschließend wird erneut eine vorher bestimmte Menge an Einheiten abgezählt und es wird erneut ein CRC-Wert in das Datenpaket eingefügt, wobei dieser CRC-Wert über die abgezählten Einheiten seit der letzten Einfügung eines CRC-Wertes gebildet wird. Das Abzählen kann wiederum dass Inkrementieren oder Dekrementieren des Zählerwertes umfassen. Erreicht der Zählerwert nicht die vorher bestimmte Menge an Einheiten also den Referenzwert aber den Anfang beziehungsweise das Ende des Datenpaketes, so wird ein CRC-Wert eingefügt, der aus dem Rest der Einheiten an Daten also den restlichen Nutzdaten und den Steuerdaten des Kopfes des Datenpaketes gebildet wird. Der Anfang oder das Ende des Datenpaketes kann beispielsweise durch das Erkennen von bestimmten Daten festgestellt werden. Beispielsweise kann erkannt werden, dass Steuerdaten vorliegen, d.h. der Kopf des Datenpaketes erreicht ist. Dabei können für den CRC-Wert alle Steuerdaten des Kopfes berücksichtigt werden oder nur ein Teil der Steuerdaten. Das Ende des Datenpaketes kann auch beispielsweise dadurch erkannt werden, dass die Länge des Datenpaketes bekannt ist, weil die Länge beispielsweise Teil des Kopfes des Datenpaketes ist.

Das erfindungsgemäße Verfahren bettet also zumindest einen CRC-Wert in das Datenpaket ein, wobei dieser eingebettete CRC-Wert immer über eine vorher bestimmte Menge an Einheiten von Daten oder die restlichen Einheiten von Daten gebildet wird, wobei die vorher bestimmte Menge an Daten korreliert sein kann mit der "Hamming-Distanz" des für den CRC-Wert verwendeten zumindest einen CRC-Polynoms. D.h. es werden vorzugsweise nie mehr Einheiten an Daten zur Bildung eines CRC-Wertes verwendet, als das die "Hamming-Distanz" zulässt, egal wie lang das Datenpaket ist. Hiervon kann für eine kleine Menge an Daten abgewichen werden, beispielsweise kann der Zählerwert nur die Nutzdaten zählen, wenn dieser aber am Ende der Nutzdaten angelangt ist und der Rest nur noch aus dem Kopf des Datenpaketes besteht, so kann der CRC-Wert auch noch über den Kopf oder zumindest einen Teil des Kopfes des Datenpaketes gebildet werden.

Das erfindungsgemäße Verfahren hat den Vorteil, dass nur ein Zählerwert vorhanden sein muss, der entsprechend der Anzahl von Einheiten der Daten geändert wird und bei Erreichen eines Referenzwertes oder eines verbleidenden Restes an Daten wird ein CRC-Wert in das Datenpaket eingefügt. Dabei kann immer das gleiche CRC-Polynom verwendet werden, auch wenn die Anzahl der Daten variabel ist. D.h. es ist nur ein marginaler Mehraufwand von Nöten im Vergleich zur Verwendung eines CRC-Polynoms mit höherer "Hamming-Distanz". Darüber hinaus können auftretende Fehler besser lokalisiert werden, so dass nicht ein komplettes Datenpaket verworfen werden muss, sondern nur ein Teil des Datenpaketes, nämlich der Teil dessen CRC-Wertüberprüfung einen Fehler anzeigt.

In einer bevorzugten Ausführungsform des erfindungsgemäßen Verfahrens werden die CRC-Werte in dem Datenpaket jeweils unmittelbar angrenzend an die Einheiten von Daten eingefügt, auf deren Grundlage sie gebildet werden. D.h. die CRC-Werte werden entweder vor oder nach den Einheiten an Daten in das Datenpaket eingefügt, auf deren Grundlage sie gebildet wurden. In diesem Zusammenhang kann man auch von eingebetteten CRC-Werten sprechen.

In einer bevorzugten Ausführungsform des erfindungsgemäßen Verfahrens ist eine Einheit an Daten eine feste Anzahl von Bits, beispielsweise ein Byte. Dem Fachmann ist aber bewusst, dass auch eine beliebige Definition der Einheiten von Daten herangezogen werden kann. Die Einheit muss nur quantifizierbar und abzählbar sein.

In einer bevorzugten Ausführungsform des erfindungsgemäßen Verfahrens wird der Zählerwert beim Initialisieren auf einen vorher bestimmten Binärwert gesetzt. Beispielsweise kann dieser vorher bestimmte Binärwert ein Vielfaches der Menge an Einheiten von Daten sein über die ein CRC-Wert gebildet werden soll, d.h. ein Vielfaches des Referenzwertes. Es ist aber auch denkbar, dass der Zählerwert auf die Länge des Datenpaketes gesetzt wird, wenn die Länge beispielsweise im Kopf des Datenpaketes oder an anderer Stelle im Datenpaket hinterlegt ist. Der verwendete Referenzwert zur Identifizierung der Menge an abgezählten Einheiten von Daten kann in seiner Binärwertdarstellung Nullen an den niedrigstwertigen Positionen aufweisen oder ausschließlich Nullen aufweisen. Anschließend wird beim Abzählen der Einheiten von Daten der Zählerwert dekrementiert. Wenn der Zählerwert an einer Anzahl der niedrigstwertigen Positionen, die der Anzahl der niedrigstwertigen Positionen mit Nullen des Referenzwertes entspricht, Nullwerte aufweist, so zeigt dies an, dass eine bestimme Menge an Einheiten an Daten abgezählt wurde. Dabei ist die Menge der abgezählten Daten gleich dem Referenzwert. Beispielsweise kann das erfindungsgemäße Verfahren eingerichtet sein, alle 2048 Einheiten von Daten einen CRC-Wert in das Datenpaket einzufügen, die Binärdarstellung dieser Zahl entspricht 100000000000 (11-Nullen). D.h. jedes Mal wenn die 11-niedriegstwertigen Positionen des binären Zählerwertes Null anzeigen, wird ein CRC-Wert eingefügt, der über die zuletzt abgezählten 2048 Einheiten von Daten gebildet wird. Dabei kann eine Einheit von Daten ein Byte sein. D.h. es können beispielsweise 2048 Byte abgezählt werden. Dem Fachmann ist aber bewusst, dass auch eine beliebige andere Anzahl von Einheiten von Daten abgezählt werden kann und dass die Anzahl durch die entsprechende Anzahl von Nullen an den niedrigstwertigen Positionen des Zählerwertes angezeigt wird. Einen derartigen Vergleich kann man auch als Nulldurchgangsvergleich bezeichnen.

In einer bevorzugten Ausführungsform des erfindungsgemäßen Verfahrens können die CRC-Werte alle mit Hilfe des gleichen CRC-Polynoms gebildet. Dies hat den Vorteil, dass nur eine Hardwareschaltung vorgehalten werden muss, die iterativ eingesetzt werden kann. Alternativ können die CRC-Werte aber auch mit unterschiedlichen CRC-Polynomen gebildet werden. Dabei können entweder alle CRC-Werte mit unterschiedlichen CRC-Polynomen gebildet werden, oder es kann eine vorher bestimmte Anzahl an CRC-Polynomen verwendet werden. Beispielswiese können zwei unterschiedliche CRC-Polynome verwendet werden und die CRC-Werte jeweils abwechselnd mit einem der zwei CRC-Polynome gebildet werden. Wenn diese CRC-Polynome unterschiedliche "Hamming-Distanzen" aufweisen, können auch weitere Referenzwerte genutzt werden. Dabei kann jeweils ein Referenzwert der "Hamming-Distanz" den momentan verwendeten CRC-Polynoms entsprechen. Beispielsweise können CRC-Polynome mit einer "Hamming-Distanz" von 2048 Bytes oder 4092 Bytes, wie beispielsweise das Castagnoli-Polynom, verwendet werden. Es ist dem Fachmann aber bewusst, dass beliebige CRC-Polynome verwendet werden können, dass aber der dazugehörige Referenzwert jeweils auf die "Hamming-Distanz" des verwendeten CRC-Polynoms abgestimmt sein muss.

In einer bevorzugten Ausführungsform des erfindungsgemäßen Verfahrens sind die Einheiten an Daten Nutzdaten und/oder Kopfdaten. Die eingebetteten CRC-Werte können dementsprechend ausgehend von Nutzdaten sowie von Kopfdaten, also Steuerdaten, des Datenpaketes gebildet werden. Dies ermöglicht eine komplette Überprüfung des Datenpaketes einschließlich der Steuerdaten.

In einer bevorzugten Ausführungsform des erfindungsgemäßen Verfahrens ist das erzeuget Datenpaket mit den eingebetteten CRC-Werten in einem Zyklusrahmen enthalten. Das Datenpaket kann auch als Telegramm bezeichnet werden. Ein Zyklusrahmen wird beispielsweise dann verwendet, wenn das Datenpaket oder mehrere Datenpakete auf einem Ringbus gesendet werden sollen. In diesem Fall kann ein Zyklusrahmen als ein wiederkehrendes (zyklisches) vorzugsweise äquidistantes Zeitintervall, in dem Daten auf dem Ringbus übertragbar sind, definiert werden. Der Zyklusrahmen weist beispielsweise zumindest eine Startkennung (SOC) und einen Zeitbereich zur Übertragung von Daten auf. Mehrere Startkennungen (SOC) aufeinander folgender Zyklusrahmen sind dabei vorteilhafterweise in einem zeitlich äquidistanten Abstand zueinander. Der genannte Zeitbereich ist für die Übertragung der Datenpakete vorgesehen. Die Startkennung (SOC) und die Datenpakete werden über den Ringbus übertragen und durchlaufen alle Datenbusteilnehmer des Ringbusses. Die Startkennung (SOC) ist separat, also als eigenständiges Symbol übertragbar oder vorteilhafterweise in einem Startdatenpaket (SOC-Paket) enthalten. Innerhalb des Zeitbereichs des Zyklusrahmens werden keine, ein oder mehrere Datenpakete übertragen. Vorteilhafterweise werden in einem Zyklusrahmen Leerlauf-Daten (Idle-Data) eingefügt, insbesondere angrenzend an zumindest ein Datenpaket. Vorteilhafterweise bewirkt die Übertragung der Datenpakete und/oder der Leerlauf-Daten ein ununterbrochenes Signal auf dem Ringbus. Das Signal ermöglicht es den Datenbusteilnehmern, sich auf dieses zeitlich zu synchronisieren. Vorteilhafterweise weist der Zyklusrahmen zusätzlich einen Trailer auf. Der Trailer hat eine variable Länge und folgt auf den Zeitbereich zur Datenübertragung vorzugsweise bis zur folgenden Startkennung (SOC) des nächsten Zyklusrahmens. Vorteilhafterweise weist der Trailer Leerlauf-Daten auf.

Die im Zyklusrahmen übertragenen Datenpakete werden vorzugsweise originär von einem Lokalbusmaster erzeugt und über den Ringbus an die Datenbusteilnehmer gesendet. Beim Erzeugen kann der Lokalbusmaster von der Steuerung, beispielsweise einer SPS, empfangene Prozessdaten in ein Datenpaket einfügen. Das Datenpaket kann aber auch Prozessdaten von dem Lokalbusmaster selbst und/oder der Steuerung enthalten. Das Datenpaket und damit die darin enthaltenen Prozessdaten und CRC-Werte durchlaufen dann schrittweise die einzelnen Datenbusteilnehmer des Ringbusses. Dabei kann das Datenpaket eine Vielzahl von Symbolen aufweisen, wobei jedes Symbol eine bestimmte Anzahl von Bits aufweist, beispielsweise 8 Bits also 1 Byte. Das Datenpaket durchläuft dementsprechend einheitenweise, stückchenweise, oder Teile weise, zum Beispiel in Form von Symbolen die Datenbusteilnehmer. Die Datenbusteilnehmer haben dementsprechend zu jeder gegebenen Zeit immer nur einen Teil des Datenpaketes vorliegen. Wenn hier also von Daten gesprochen wird, so kann dies auch meinen, ein Symbol des Datenpaketes, das gerade den Ringbus durchläuft.

Ein Datenpaket welches Prozessdaten trägt kann auch als Prozessdatenpaket bezeichnet werden. Das Prozessdatenpaket weist die Prozessdaten auf, die von den Datenbusteilnehmern des Lokalbusses gesendet und/oder empfangen werden. Vorteilhafterweise weist das Prozessdatenpaket keine Adresse zur Übertragung der Prozessdaten an einen oder von einem Datenbusteilnehmer im Lokalbus auf. In dem Prozessdatenpaket sind die Prozessdaten derart angeordnet, dass Datenbusteilnehmer auf Grund der jeweiligen Position der Prozessdaten in dem Prozessdatenpaket, beispielsweise ein oder mehrere Bits innerhalb eines zugeordneten zusammenhängenden Datenblocks (1 Byte), diejenigen dem jeweiligen Datenbusteilnehmer zugehörigen Prozessdaten erkennen können. Vorteilhafterweise weist das Prozessdatenpaket eine Kennung (IDE) auf, die dem Typ des Datenpaketes, also dem Prozessdatenpaket zugeordnet und durch den Datenbusteilnehmer identifizierbar ist. Ein Datenpaket kann aber auch ein Kommunikationsdatenpaket sein, welches keine Prozessdaten aufweist und insbesondere zum Programmieren und/oder zum Steuern und/oder zum Überwachen und/oder zum Identifizieren zumindest eines Datenbusteilnehmers dient. Vorteilhafterweise weist das Kommunikationsdatenpaket eine Adresse auf, die mindestens einem Datenbusteilnehmer zugeordnet ist. Vorzugsweise ist der Datenbusteilnehmer eingerichtet, die Adresse auszuwerten und das Kommunikationsdatenpaket entsprechend zu verarbeiten.

Bei denen im Zyklusrahmen verwendeten Datenpakten sind die erfindungsgemäß eingebetteten CRC-Werte unabdingbar und haben den Vorteil, dass die Länge der Datenpakete und damit die Länge der zu sendenden Prozessdaten nicht beschränkt ist auf eine bestimmte Anzahl vorgegeben durch die "Hamming-Distanz" eines entsprechenden CRC-Polynoms. Auch ist Vorteilhaft, dass die Datenbusteilnehmer in die Lage versetzt werden nur einen Teil der Datenpakete zu überprüfen, nämlich jeweils die Teile über die der jeweilige CRC-Wert gebildet wurde, ohne dass der Datenbusteilnehmer das ganze Datenpaket vorliegen haben müsste. Dies wiederum bedeutet, dass der Datenbusteilnehmer einen geringeren Speicherbedarf hat, als wenn dieser das komplette Datenpaket zur Überprüfung zwischenspeichern müsste.

Die der Erfindung zu Grunde liegende Aufgabe wird auch durch eine Vorrichtung zur Bildung eines zu übertragenden Datenpaketes mit Daten und zumindest einem Wert zur zyklischen Redundanzprüfung gelöst. Dabei wird der zumindest eine CRC-Wert mit Hilfe von zumindest einem vorherbestimmten Polynom auf der Grundlage zumindest eines Teils der Daten gebildet. Die Vorrichtung weist ein Mittel zum Initialisieren eines Zählerwertes, ein Mittel zum Abzählen von Einheiten von Daten, wobei das Mittel angepasst ist für jede Einheit von Daten den Zählwert zu ändern, ein Mittel zum Bilden eines CRC-Wertes sowie ein Mittel zum Einfügen des zumindest einen CRC-Wertes in dem Datenpaket auf. Dabei ist das Mittel zum Abzählen von Einheiten von Daten angepasst den Zählerwert zu ändern basierend auf den abgezählten Einheiten von Daten. Dabei kann die Vorrichtung des Weiteren ein Mittel zum Anzeigen des Zählerwertes aufweisen. Das Mittel zum Bilden eines CRC-Wertes kann angepasst sein den CRC-Wert über die abgezählten Einheiten von Daten zu bilden seit dem der Zählerwert das letzte Mal den Referenzwert erreicht hat oder der Zählerwert initialisiert wurde. Des Weiteren kann die Vorrichtung ein Mittel zum Ausgeben des Zählerwertes aufweisen. Dabei können die Mittel in einer arithmetische-logischen Einheit, einer Rechenschaltung, einem Mikrocontroller, oder einer anderen digitalen logischen Schaltung implementiert sein, die als ein Teil eines Halbleiterchips ausgebildet ist und in einem integrierten Schaltkreis (*engl.* ASIC), oder in einer Feld programmierbaren (Logik-)Gatter-Anordnung (*engl.* FPGA), oder in einer anderen programmierbaren Schaltung (*engl.* PLD), oder einer diskreten Gatter oder Transistorlogik implementiert ist.

Die der Erfindung zu Grunde liegende Aufgabe wird auch durch ein Verfahren zur Überprüfung eines empfangenen Datenpaketes mit zumindest einem Wert zur zyklischen Redundanzprüfung, CRC-Wert gelöst. Dabei ist der zumindest eine CRC-Werte mit Hilfe von zumindest einem vorherbestimmten Polynom auf der Grundlage zumindest eines Teils der Daten gebildet worden und in das Datenpaket eingefügt worden. Das Verfahren weist auf Initialisieren eines Zählerwertes, Abzählen von Einheiten von Daten von dem empfangenen Datenpaket, wobei für jede Einheit von Daten der Zählerwert geändert wird und Erkennen eines CRC-Wertes in den Daten, wenn der Zählerwert einen Referenzwert erreicht hat oder alle Einheiten von Daten in dem Datenpaket bereits abgezählt wurden und Überprüfen des erkannten CRC-Wertes. Das Überprüfen des CRC-Wertes kann dabei anhand von einer Polynomdivision mit dem bekannten CRC-Polynom geschehen. Dabei sind die Daten zugehörig zu dem jeweiligen CRC-Wert fehlerfrei empfangen, wenn die Polynomdivision jeweils einen Rest von Null anzeigt. Das ganze Datenpaket ist fehlerfrei empfangen, wenn alle Überprüfungen keinen Fehler zeigen, d.h. alle durchgeführten Polynomdivisionen jeweils einen Rest von Null zeigen.

In einer bevorzugten Ausführungsform des erfindungsgemäßen Verfahrens weist dieses auf, dass der Zählerwert beim Initialisieren auf einen vorbestimmten Binärwert gesetzt wird und wobei beim Abzählen der Einheiten von Daten der Zählerwert dekrementiert wird und der Referenzwert ein Binärwert mit Nullwerten an den niedrigstwertigen Positionen ist. Dies führt dazu, dass immer wenn der Zählerwert bei einem Nulldurchgangsvergleich anzeigt, dass eine bestimmte Menge an Einheiten an Daten abgezählt wurde, erkannt wird, dass ein CRC-Wert vorliegt, der überprüft werden kann.

In einer bevorzugten Ausführungsform des erfindungsgemäßen Verfahrens wird die Überprüfung der CRC-Werte jeweils mit dem gleichen CRC-Polynom durchgeführt.

In einer bevorzugten Ausführungsform des erfindungsgemäßen Verfahrens ist das zu überprüfende Datenpaket in einem Zyklusrahmen enthalten und das Verfahren weist weiter auf das Empfangen des Datenpaketes von einem Datenbusteilnehmer.

Die der Erfindung zu Grunde liegende Aufgabe wird auch durch ein Verfahren zur Überprüfung eines empfangenen Datenpaketes mit Daten und zumindest einem Wert zur zyklischen Redundanzprüfung, CRC-Wert, gelöst. Dabei ist ein erster CRC-Wert mit Hilfe von zumindest einem vorherbestimmten Polynom auf der Grundlage zumindest eines ersten Teils der Daten gebildet und ein zweiter CRC-Wert ist mit Hilfe von dem vorherbestimmten Polynom auf der Grundlage zumindest eines zweiten Teils der Daten gebildet. Das Verfahren weist auf Initialisieren eines Zählerwertes, Abzählen von Einheiten des ersten Teils von Daten von dem empfangenen Datenpaket, wobei für jede Einheit von Daten der Zählerwert geändert wird, Erkennen des ersten CRC-Wertes in den Daten, wenn der Zählerwert einen Referenzwert erreicht, Erkennen des zweiten CRC-Wertes in den Daten, wenn alle Einheiten von Daten in dem Datenpaket bereits abgezählt wurden und Überprüfen der erkannten CRC-Werte. Dabei kann beispielsweise erkannt werden, dass das Datenpaket fehlerfrei empfangen wurde, wenn alle Überprüfungen der erkannten CRC-Werte keine Fehler aufzeigen.

In einer bevorzugten Ausführungsform des erfindungsgemäßen Verfahrens wird beim Initialisieren der Zählerwert auf einen Binärwert gesetzt, der Binärwert kann dabei beispielsweise von der Länge des Datenpaketes abhängig sein. Die Länge des Datenpaketes kann beispielsweise aus dem Kopfteil des Datenpaketes bekannt sein. Beim Abzählen der Einheiten wird der Zählerwert beispielsweise dekrementiert und wird mit dem Referenzwert, der beispielsweise ausschließlich Nullwerte aufweist verglichen.

Die der Erfindung zu Grunde liegende Aufgabe wird auch durch eine Vorrichtung zur Überprüfung eines empfangenen Datenpaketes mit zumindest einem Wert zur zyklischen Redundanzprüfung, CRC-Wert, gelöst. Dabei ist der CRC-Wert mit Hilfe von zumindest einem vorherbestimmten Polynom auf der Grundlage zumindest eines Teils der Daten des Datenpaketes gebildet worden und in das Datenpaket eingefügt worden. Die Vorrichtung weist auf ein Mittel zum Empfangen eines Datenpaketes, ein Mittel zum Initialisieren eines Zählerwertes, ein Mittel zum Abzählen von Einheiten von Daten von dem empfangenen Datenpaket, wobei für jede Einheit von Daten der Zählerwert geändert wird, ein Mittel zum Erkennen eines CRC-Wertes in den Daten des Datenpaketes, wenn der Zählerwert einen Referenzwert erreicht hat oder alle Einheiten von Daten in dem Datenpaket bereits abgezählt wurden und ein Mittel zum Überprüfen des erkannten CRCs.

### 4. Kurze Beschreibung der Zeichnungen

Die Erfindung wird nachfolgend anhand von Ausführungsbeispielen mit den beigefügten Zeichnungen näher erläutert. Aus dem beschriebenen Ausführungsbeispielen ergeben sich weitere Einzelheiten, Merkmale und Vorteile des Gegenstands der Erfindung. Es zeigen:
- Fig. 1: ein exemplarisches Datenpaket mit einem CRC-Wert;
- Fig. 2: ein exemplarisches Datenpaket mit zwei CRC-Werten;
- Fig. 3: ein exemplarisches Datenpaket mit drei CRC-Werten;
- Fig. 4: ein exemplarisches erfindungsgemäßes Verfahren zum Bilden eines Datenpaketes mit einem oder mehreren CRC-Werten;
- Fig. 5: ein exemplarisches erfindungsgemäßes Verfahren zum Überprüfen eines Datenpaketes mit einem oder mehreren CRC-Werten; und
- Fig. 6: ein schematisches Blockdiagramm einer beispielhaften Automatisierungsanlage mit einer speicherprogrammierbaren Steuerung, einem übergeordneten Bus, und mehreren beispielhaften Datenbusteilnehmern in der die erfindungsgemäßen Datenpakete zum Einsatz kommen.

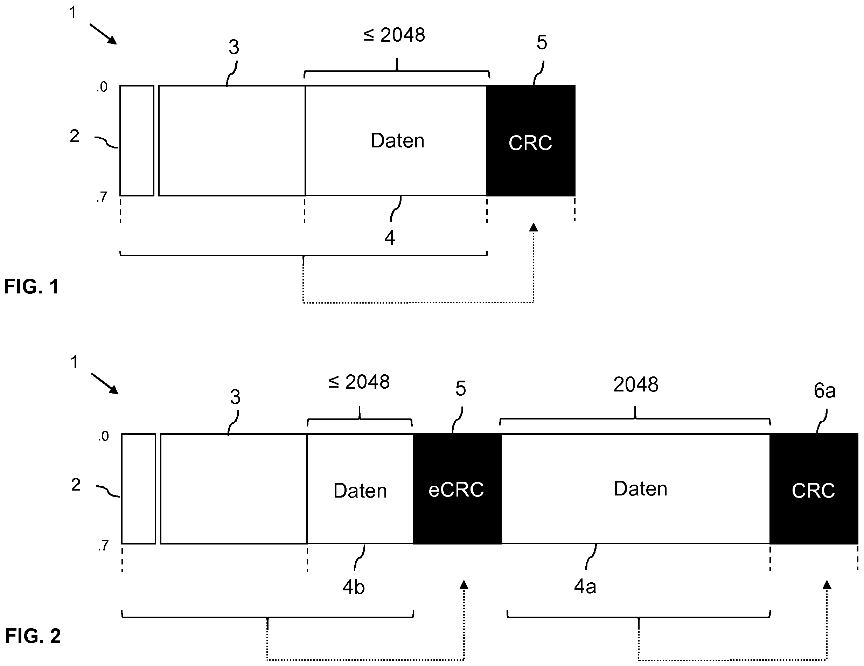

Figur 1 zeigt exemplarisch ein Datenpaket 1 mit einem Kopfteil bestehend aus einem eineindeutigen Bitmuster 2 und einem Steuerdatenteil 3. Das eineindeutige Bitmuster 2 ist ein nur einmal auftretendes Bitmuster und markiert den Anfang eines Datenpaketes 1. Ein derartiges Bitmuster 2 kann auch als Codewort oder Kennung bezeichnet werden. Die Ausgestaltung von eindeutigen Bitmustern 2 beziehungsweise Codewörtern hängt dabei von der Kodierung ab mit der das Datenpaket 1 gesendet wird. Der Steuerdatenteil 3 kann Steuerdaten beinhalten, die Informationen bezüglich des Datenpaketes 1 enthalten oder anderweitige Information, die von dem oder den Empfängern des Datenpaketes 1 verwendet werden können. Dem Fachmann sind eine Vielzahl von Steuerdaten bekannt, die in einem Datenpaket 1 enthalten sein können.

Der Informationsteil des Datenpaktes 1 umfasst die Daten 4, die auch als Nutzdaten oder Prozessdaten bezeichnet werden können und die geeignet sind an den Empfängern eine Steuerung, Regelung oder anderweitige Auswertung hervorzurufen. Die Nutzdaten oder Prozessdaten können aber auch dazu ausgelegt sein, die von ihnen dargestellte Information an einen oder mehrere Empfänger zu transportieren.

In dem hier gezeigten Ausführungsbeispiel umfasst das Datenpaket 1 genau einen CRC-Wert 5. Dieser CRC-Wert 5 ist mit Hilfe eines CRC-Polynoms aus den Daten 4 und dem Kopfteil 2, 3 gebildet. In dem hier gezeigten Ausführungsbeispiel wurde nur ein CRC-Wert 5 in das Datenpaket 1 eingefügt, weil die Menge der Daten in dem hier gezeigten Ausführungsbeispiel kleiner als 2048 Bytes ist. D.h. in dem hier gezeigten Ausführungsbeispiel wird ein CRC-Polynom verwendet, welches eine "Hamming-Distanz" aufweist mit der ein CRC-Wert 5 für mindestens 2048 Bytes eindeutig erstellt werden kann. Beim Bilden des Datenpaketes 1 wurde zunächst ein Zählerwert initialisiert, beispielswiese auf ein Vielfaches eines Referenzwertes, d.h. auf ein Vielfaches von 2048 Bytes oder auf die Länge des Datenpaketes 1. Anschließend wurden die Einheiten an Daten 4 abgezählt. Dabei hat der Zählerwert nicht den Referenzwert von 2048 Bytes erreicht bevor das Ende der Daten 4 beziehungsweise das eineindeutige Bitmuster 2 erreicht wurde. Der CRC-Wert 5 ist dementsprechend über die gesamten Daten 4 und den Kopfteil 2, 3 gebildet worden und an die Daten 4 angefügt worden.

Figur 2 zeigt exemplarisch ein Datenpaket 1 mit zwei eingefügten CRC-Werten 5, 6a. In dem hier gezeigten Ausführungsbeispiel enthält das Datenpaket 1 mehr als den Referenzwert von 2048 Bytes an Daten 4. Durch Abzählen der Daten 4 mit einem Zählerwert wird, wenn der Zählerwert einen Referenzwert erreicht, ein erster CRC-Wert 6a aus den abgezählten ersten Daten 4a gebildet. Dieser erste CRC-Wert 6a wird den abgezählten Daten 4a angefügt. In dem hier gezeigten Ausführungsbeispiel ist der Rest an Daten 4b kleiner als der Referenzwert. Bevor der Zählerwert also erneut den Referenzwert erreicht, wird das Ende des Datenpaketes 1 erreicht. Es wird dementsprechend ein CRC-Wert 5 gebildet aus den restlichen Daten 4b und dem Kopfteil 2,3 des Datenpaketes 1. Dieser CRC-Wert 5 wird den restlichen Daten 4b angefügt. Auf diese Weise entsteht ein Datenpaket 1 mit zwei CRC-Werten 5, 6a, wobei der zweite CRC-Wert 5 als eingebetteter CRC-Wert, also eCRC-Wert, bezeichnet werden kann, weil dieser zwischen die Daten 4a, 4b eingefügt ist. Die beiden CRC-Werte 5, 6a können dabei mit dem gleichen CRC-Polynom gebildet werden unterscheiden sich aber auf Grund der Daten auf Basis derer sie gebildet werden. Der CRC-Wert 6a basiert auf den Daten 4a und der eCRC-Wert 5 basiert auf den Daten 4b und in dem hier gezeigten Ausführungsbeispiel auch auf dem Kopfteil 2, 3. Es ist dem Fachmann klar, dass auch wenn hier beschrieben ist, dass beide CRC-Werte 5, 6a mit Hilfe des gleichen CRC-Polynoms gebildet wurden, hier auch unterschiedliche CRC-Polynome eingesetzt werden können.

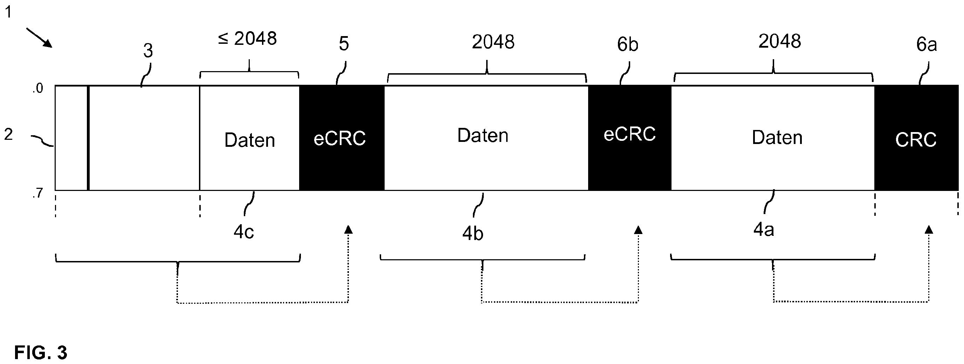

Figur 3 zeigt exemplarisch ein Datenpaket 1 mit drei CRC-Werten 5, 6a, 6b, wobei zumindest zwei der drei CRC-Werte 5, 6b eingebettete CRC-Werte 5, 6b sind. Bei der Bildung des Datenpaketes 1 wurde ein Zählerwert beispielsweise auf ein Vielfaches des Referenzwertes gesetzt, beispielsweise auf 6144 Bytes (3 × 2048 Bytes). Es ist dem Fachmann aber bewusst, dass der Zählerwert beliebig gesetzt werden kann und beispielsweise auf die Länge des Datenpaketes gesetzt werden kann, falls diese bekannt ist.

In dem hier gezeigten Ausführungsbeispiel wird für jedes Byte an Daten 4 im Datenpaket 1 der Zählerwert dekrementiert. Zur Vereinfachung des Abzählens der Daten 4 kann das Abzählen binär geschehen und die niedrigstwertigen Positionen in der Binärdarstellung des Zählerwertes können verwendet werden, um einen Nulldurchgangsvergleich durchzuführen. D.h. immer wenn alle niedrigstwertigen Positionen in der Binärdarstellung des Zählerwertes gleich Null sind, so ist eine dem Referenzwert entsprechende Menge an Daten 4 abgezählt worden. Dieser Nulldurchgangsvergleich ist exemplarisch in Tabelle 1 dargestellt.

**Tabelle 1**

| | |
|---|---|
| 6144 Bytes | 1100000000000 |
| ... | |
| 4097 Bytes | 1000000000001 |
| 4096 Bytes | 1000000000000 |
| 4095 Bytes | 0111111111111 |
| ... | |
| 2049 Bytes | 0100000000001 |
| 2048 Bytes | 0100000000000 |
| 2047 Bytes | 0011111111111 |

Die Tabelle 1 geht dabei von einem initialisierten Zählerwert von 6144 Bytes aus. Für die Binärdarstellung dieses Wertes sind 13 Positionen nötig. Es werden aber immer nur die niedrigstwertigen Positionen betrachtet, wobei die Anzahl der niedrigstwertigen Positionen der Anzahl an niedrigstwertigen Positionen entspricht, die zur Darstellung des Referenzwertes nötig sind. Der Referenzwert kann dabei der "Hamming-Distanz" des verwendeten CRC-Polynoms entsprechen. In dem hier gezeigten Ausführungsbeispiel ist der Referenzwert mit 12 Positionen darstellbar ("Hamming-Distanz" von 2048 Bytes), d.h. 11 Positionen sind die niedrigstwertigen Positionen und damit relevant. Wird der Zählerwert von 6144 Bytes dekrementiert, so erfahren die letzten 11 Positionen einen Nulldurchgang bei genau 4096 Bytes sowie bei 2048 Bytes und 0 Bytes. Wenn diese Nulldurchgänge erfahren werden, wurden also immer genau die Anzahl an Daten 4 abgezählt, die dem Referenzwert entsprechen. In dem hier gezeigten Ausführungsbeispiel wurde der Zählerwert mit 6144 Bytes initialisiert und beim ersten Nulldurchgang wurde der CRC-Wert 6a eingefügt. Dieser wurde über die Daten 4a gebildet. Beim zweiten Nulldurchgang wurde der eCRC-Wert 6b eingefügt. Dieser wurde über die Daten 4b gebildet. Einen weiteren Nulldurchgang gibt es in dem hier gezeigten Ausführungsbeispiel nicht mehr, weil die restlichen Daten 4c weniger als 2048 Bytes sind. D.h. es wird bereits das Ende der Daten 4 erreicht beziehungsweise des Ende des Datenpaketes 1 angezeigt durch das eineindeutige Bitmuster 2, bevor der Zählerwert erneut einen Nulldurchgang erfährt. Der weitere eCRC-Wert 5 wird dementsprechend über die restlichen Daten 4c und den Kopfteil 2, 3 gebildet und den Daten 4c angefügt.

In denen in Figur 1 bis 3 gezeigten Ausführungsbeispielen wird ein Referenzwert von 2048 Bytes verwendet. Dem Fachmann ist aber bewusst, dass auch ein anderer Referenzwert verwendet werden kann, der entsprechend der "Hamming-Distanz" des gewählten CRC-Polynoms ausgewählt wird. In dem hier gezeigten Ausführungsbeispielen wurde nur ein bestimmter Referenzwert vorgegeben, um die Beschreibung zu vereinfachen. Dieser ist aber nicht als beschränkend zu verstehen und jeder beliebige Referenzwert unter den zuvor genannten Voraussetzungen ist denkbar. Des Weiteren ist dem Fachmann bewusst, dass auch wenn in den gezeigten Ausführungsbeispielen immer der gesamte Kopfteil 2, 3 des Datenpaktes 1 mit berücksichtigt wurde zur Bildung des zuletzt einzufügenden eCRC-Wertes 5, dieser Wert auch nur über die Nutzdaten 4 gebildet werden kann, ohne den Kopfteil 2, 3. Es ist auch vorstellbar, dass der zuletzt einzufügende eCRC-Wert 5 nur über einen Teil des Kopfteiles 2, 3 gebildet wird, zum Beispiel die Steuerdaten 3 aber nicht über das eineindeutige Bitmuster 2. Des Weiteren ist dem Fachmann bekannt, dass auch wenn hier ein Nulldurchgangsvergleich verwendet wird, um zu erkennen, dass eine bestimmte Menge an Daten 4 abgezählt wurde, auch ein Einsdurchgangsvergleich verwendet werden kann, wenn beispielsweise der Zählerwert nicht dekrementiert wird, sondern inkrementiert wird. Wenn also von Null an gezählt wird, so zeigen lauter Einsen an den niedrigswertigen Positionen der Binärdarstellung des Zählerwertes an, dass der Referenzwert erreicht ist. Dies kann beispielsweise in Tabelle 1 gesehen werden. Wenn von Null an gezählt wird, so sind die niedrigswertigen Positionen bei 2047 und 4095 Bytes etc. immer aus lauter Einsen gebildet. Diese können verwendet werden um anzuzeigen, dass eine Menge an Daten abgezählt wurde, die dem Referenzwert entspricht. Des Weiteren ist dem Fachmann bewusst, dass auch wenn hier ein Vielfaches des Referenzwertes als Startwert für den Zählerwert verwendet wurde, der Zählerwert auch in Abhängigkeit der Länge des Datenpaketes 1 gesetzt werden kann, sofern diese Länge bekannt ist.

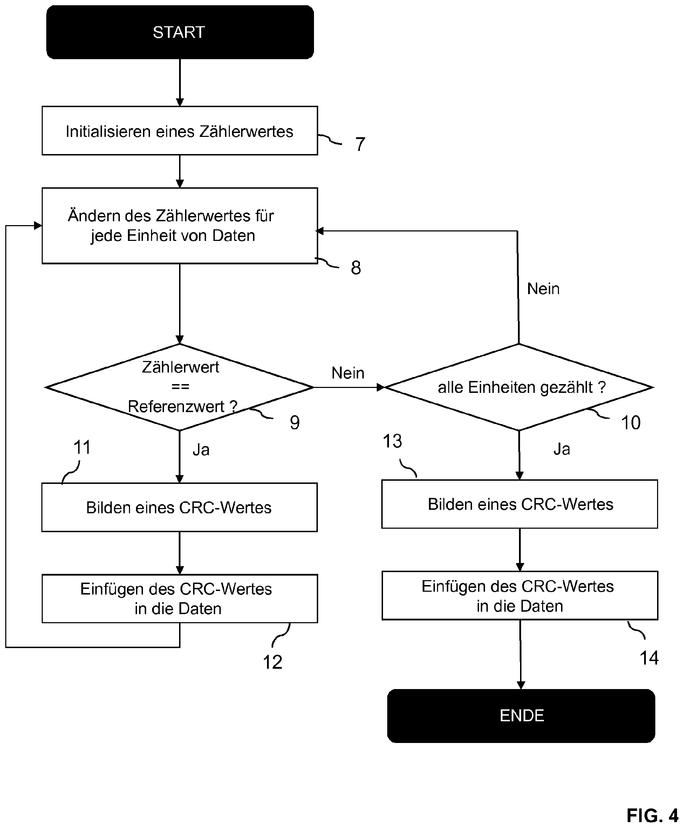

Figur 4 zeigt exemplarisch die Schritte des erfindungsgemäßen Verfahrens zum Bilden eines Datenpaketes 1 - wie in den Figuren 1 bis 3 gezeigt - mit einem oder mehreren CRC-Werten 5, 6 in einem Flussdiagramm. Dabei wird im ersten Schritt 7 ein Zählerwert initialisiert, beispielsweise auf ein Vielfaches eines Referenzwertes, also auf ein Vielfaches einer "Hamming-Distanz" eines verwendeten CRC-Polynoms oder auf die Länge des Datenpaketes 1. Anschließend werden in Schritt 8 Einheiten von Daten 4 in dem Datenpaket 1 abgezählt und der Zählerwert für jede Einheit von Daten 4 geändert. Das Ändern kann dabei in einem Dekrementieren oder Inkrementieren des Zählerwertes bestehen. Die Einheiten von Daten 4 können dabei beispielsweise Bytes sein. Es kann auch sein, dass nur Nutzdaten abgezählt werden und Steuerdaten, die den Kopfteil 2, 3 des Datenpaketes bilden, bei der Zählung unberücksichtigt bleiben, weil diese beispielsweise nur eine geringe Anzahl von Bytes aufweisen. Anschließend wird im Schritt 9 ein Vergleich des Zählerwertes mit einem Referenzwert durchgeführt. Der Referenzwert kann dabei die Menge an Einheiten von Daten 4 angeben, die mit dem ausgewählten CRC-Polynom noch zu einem eindeutigen CRC-Wert 5, 6 führen. Der Referenzwert kann aber auch etwas kleiner gewählt werden als die maximale Menge an Einheiten an Daten 4, die mit dem ausgewählten CRC-Polynom noch zu einem eindeutigen CRC-Wert 5, 6 führen, um die Sicherheit zu erhöhen, dass ein Fehler mit Hilfe des CRC-Wertes 5, 6 erkennbar ist. Entspricht der Zählerwert nicht dem Referenzwert, so wird in Schritt 10 eine Überprüfung durchgeführt, ob bereits alle Daten 4 des Datenpaketes 1 abgezählt wurden. Diese Überprüfung kann beispielsweise darin bestehen, die letzte Einheit an Daten 4 mit einem eineindeutigen bekannten Bitmuster zu vergleichen, welches den Anfang des Datenpaketes 1 anzeigt. Ist diese Überprüfung negativ, wurde also noch nicht das Ende des Datenpaketes 1 erreicht, so wiederholt das Verfahren erneut den Schritt 8, also ändert den Zählerwert, d.h. zählt eine weitere Einheit an Daten 4. Das Ende des Datenpaketes kann beispielsweise auch durch die bekannte Länge des Datenpaketes 1 erkannt werden. Anschließend wird erneut in Schritt 9 überprüft, ib der Zählerwert einem Referenzwert entspricht. Wenn dies nicht der Fall ist, so wird erneut in Schritt 10 überprüft, ob das Ende des Datenpaketes 1 erreicht ist. Die Schritte 8, 9, und 10 werden so lange wiederholt, bis entweder die Überprüfung in Schritt 9 oder die Überprüfung in 10 positiv ist.

Im Falle dessen, dass die Überprüfung in Schritt 9 positiv ist, so wird im Schritt 11 ein CRC-Wert 6a, 6b gebildet und zwar nur über die abgezählten Einheiten an Daten 4a, 4b. Dieser gebildet CRC-Wert 6a, 6b wird dann in Schritt 12 in das Datenpaket 1 eingefügt. Dabei kann der CRC-Wert 6a, 6b den abgezählten Einheiten an Daten 4a, 4b vorangestellt oder angefügt werden. Anschließend wird erneut zu Schritt 8 zurückgekehrt und weitere Einheiten an Daten 4 gezählt, d.h. für jede weitere Einheit an Daten 4 wird der Zählerwert geändert.

Im Falle dessen, dass die Überprüfung im Schritt 10 positiv ist, d.h. das Ende des Datenpaketes 1 erreicht ist, so wird über die Menge der zuletzt gezählten Einheiten an Daten 4 in Schritt 13 ein CRC-Wert 5 gebildet. Dieser CRC-Wert 5 kann auch über die Daten einschließlich des Kopfteiles 2, 3 des Datenpaketes 1 gebildet werden. In Schritt 14 wird dieser gebildete CRC-Wert 5 dann in das Datenpaket 1 eingefügt. D.h. der CRC-Wert 5 wird den zuletzt gezählten Daten 4 entweder vorangestellt oder angefügt. Mit dem Erreichen des Endes des Datenpaketes 1 wird das Verfahren beendet.

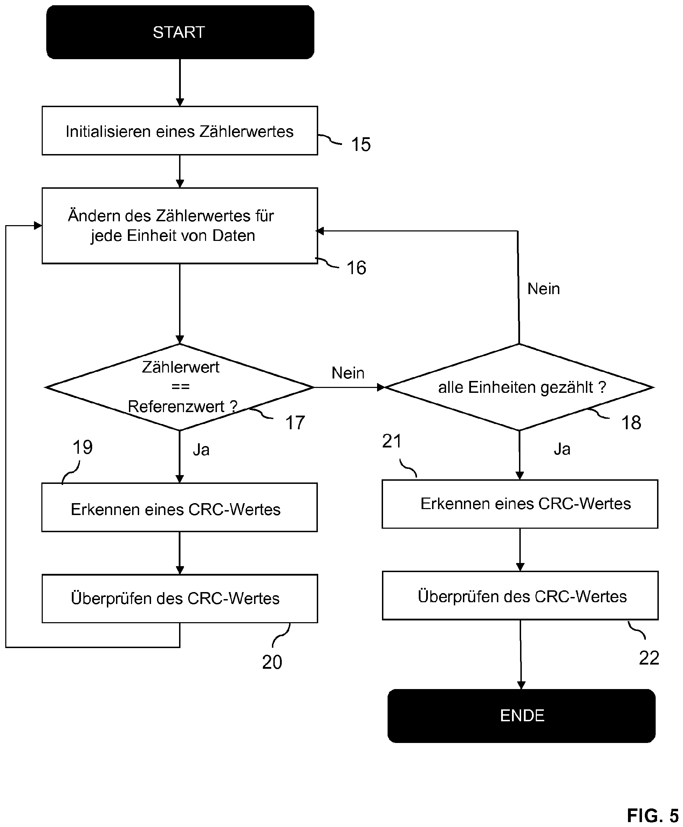

Figur 5 zeigt exemplarisch die Schritte des erfindungsgemäßen Verfahrens zur Überprüfung eines Datenpaketes 1 - wie in den Figuren 1 bis 3 gezeigt - mit einem oder mehreren CRC-Werten 5, 6 in einem Flussdiagramm. Dabei wird im ersten Schritt 15 ein Zählerwert initialisiert, beispielsweise auf ein Vielfaches eines Referenzwertes, also auf ein Vielfaches einer "Hamming-Distanz" eines verwendeten CRC-Polynoms oder auf die Länge des Datenpaketes 1. Anschließend werden in Schritt 16 Einheiten von Daten 4 in dem Datenpaket abgezählt und der Zählerwert für jede Einheit von Daten 4 geändert. Das Ändern kann dabei in einem Dekrementieren oder Inkrementieren des Zählerwertes bestehen. Die Einheiten von Daten 4 können dabei beispielsweise Bytes sein. Anschließend wird im Schritt 17 ein Vergleich des Zählerwertes mit einem Referenzwert durchgeführt. Der Referenzwert kann dabei eine Menge an Einheiten von Daten 4 angeben, die mit dem ausgewählten CRC-Polynom noch zu einem eindeutigen CRC-Wert 5, 6 führen. Der Referenzwert kann aber auch etwas kleiner gewählt werden als die maximale Menge an Einheiten an Daten 4, die mit dem ausgewählten CRC-Polynom noch zu einem eindeutigen CRC-Wert 5, 6 führen, um die Sicherheit zu erhöhen, dass ein Fehler mit Hilfe des CRC-Wertes 5, 6 erkennbar ist. Entspricht der Zählerwert nicht dem Referenzwert, so wird in Schritt 18 eine Überprüfung durchgeführt, ob bereits alle Daten des Datenpaketes 1 abgezählt wurden. Diese Überprüfung kann beispielsweise darin bestehen, die letzte Einheit an Daten 4 mit einem eineindeutigen bekannten Bitmuster zu vergleichen, welches den Anfang des Datenpaketes 1 anzeigt. Ist diese Überprüfung negativ, wurde also noch nicht das Ende des Datenpaketes 1 erreicht, so wiederholt das Verfahren erneut den Schritt 16, also ändert den Zählerwert, d.h. zählt eine weitere Einheit an Daten 4. Anschließend wird erneut in Schritt 17 überprüft, ob der Zählerwert einem Referenzwert entspricht. Wenn dies nicht der Fall ist, so wird erneut in Schritt 18 überprüft, ob das Ende des Datenpaketes 1 erreicht ist. Das Ende des Datenpaketes 1 kann beispielsweise auch durch die bekannte Länge des Datenpaketes 1 erkannt werden. Die Schritte 16, 17, und 18 werden so lange wiederholt, bis entweder die Überprüfung in Schritt 17 oder die Überprüfung in 18 positiv ist.

Im Falle dessen, dass die Überprüfung in Schritt 17 positiv ist, so wird im Schritt 19 ein CRC-Wert 5, 6 in den Daten 4 erkannt und extrahiert. Im folgenden Schritt 20 wird dann mit den abgezählten Daten 4 und dem extrahierten CRC-Wert 5, 6 eine

Überprüfung der Daten vorgenommen. Diese kann ergeben, dass die Daten fehlerhaft oder fehlerfrei sind. Im Falle dessen, dass ein Fehler erkannt wurde, so kann beispielsweise das Datenpaket verworfen werden.

Im Falle dessen, dass die Überprüfung im Schritt 18 positiv ist, d.h. das Ende des Datenpaketes 1 erreicht ist, so wird in Schritt 21 ein CRC-Wert 5 in den Daten 4c erkannt und extrahiert. Im folgenden Schritt 22 wird dann mit den abgezählten Daten 4c und dem extrahierten CRC-Wert 5 eine Überprüfung der Daten 4c vorgenommen. Diese kann ergeben, dass die Daten 4c fehlerhaft oder fehlerfrei sind. Mit dem Erreichen des Endes des Datenpaketes 1, wird das Verfahren beendet.

Optional kann vor dem Ende des Verfahrens - hier nicht gezeigt - noch eine Bestimmung erfolgen, ob das Datenpaket 1 fehlerfrei oder fehlerhaft ist. Beispielsweise kann dabei angegeben werden, welcher der erkannten CRC-Werte 5, 6 und die dazugehörigen Daten 4 einen Fehler aufweisen. Mit dieser Information kann geprüft werden, wie viele Teile des Datenpaketes 1 fehlerhaft sind und diese Teile können verworfen werden, oder das ganze Datenpaket 1 kann verworfen werden. Beispielsweise wird das ganze Datenpaket 1 verworfen, wenn die Anzahl der fehlerhaften Datenteile einen Grenzwert übersteigt.

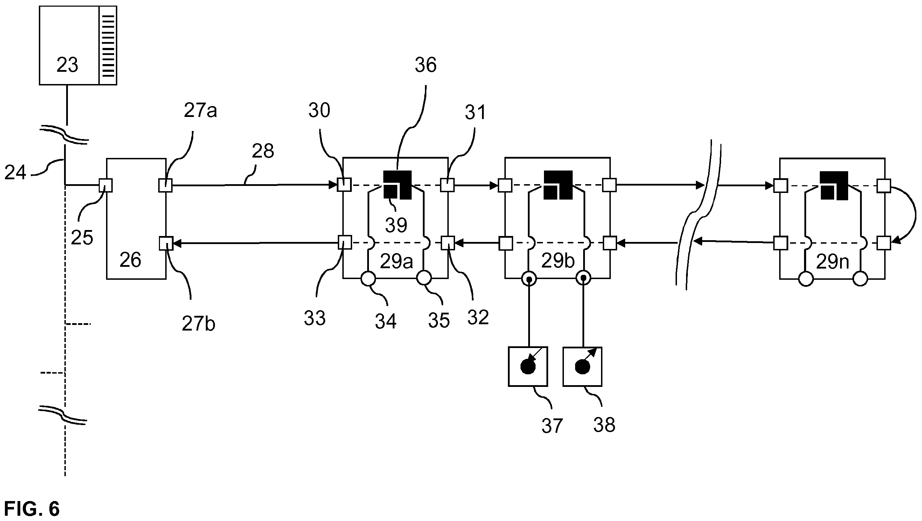

Die in den obigen Ausführungsbeispielen beschriebenen eingebetteten CRC-Werte 5, 6 und die Verfahren zur Bildung entsprechender Datenpakete 1 beziehungsweise deren Überprüfung kommen zumeist in Ringbuskommunikationen zum Einsatz, wo die Länge der Datenpakete 1 in einem Zyklusrahmen variabel sein kann und von den zu transportierenden Daten 4 und der Anzahl der am Ringbus angeschlossenen Datenbusteilnehmer abhängig ist. Ein Beispiel eines Ringbusses eingesetzt in einer beispielhaften Automatisierungsanlage ist in Figur 6 gezeigt.

Figur 6 zeigt ein schematisches Blockdiagramm einer Automatisierungsanlage. Es wird vom Fachmann verstanden werden, dass die gezeigte Automatisierungsanlage nur beispielhaft ist und alle zu der Automatisierungsanlage gehörenden Elemente, Module, Bauteile, Teilnehmer und Einheiten verschieden ausgestaltet sein können aber dennoch die hier beschriebenen Grundfunktionalitäten erfüllen können.

Die in Figur 6 gezeigte Automatisierungsanlage weist eine übergeordnete Steuerung 23 auf, die beispielsweise mit einer speicherprogrammierbaren Steuerung, SPS, realisiert werden kann. Eine derartige SPS 23 dient grundsätzlich zur Steuerung und Regelung des von der Automatisierungsanlage ausgeführten Prozesses. Heutzutage übernehmen SPSs 23 in Automatisierungsanlagen allerdings auch weitergehende Funktionen, wie zum Beispiel die Visualisierung, Alarmierung und Aufzeichnung aller den Prozess betreffenden Daten und als solche fungiert die SPS 23 als eine Mensch-Maschine Schnittstelle. Es gibt SPS 23 in unterschiedlichen Leistungsklassen, die unterschiedliche Ressourcen (Rechenkapazität, Speicherkapazität, Anzahl und Art von Ein- und Ausgängen, und Schnittstellen) aufweisen, die es der SPS 23 ermöglichen den Prozess der Automatisierungsanlage zu steuern und zu regeln. Eine SPS 23 hat zumeist einen modularen Aufbau und besteht aus einzelnen Komponenten, die jeweils eine andere Aufgabe erfüllen. Üblicherweise besteht eine SPS 23 aus einer zentralen Rechenbaugruppe (mit einem oder mehreren Hauptprozessoren und Speichermodulen) und mehreren Baugruppen mit Eingängen und Ausgängen. Derartige modular aufgebaute SPS 23 lassen sich durch Hinzufügen von Baugruppen leicht erweitern. Hierbei hängt es von der Komplexität des Prozesses und der Komplexität des Aufbaus der Automatisierungsanlage ab, welche Baugruppen in der SPS 23 integriert sein müssen. In heutigen Automatisierungsanlagen ist die SPS 23 auch zumeist kein unabhängiges System mehr, sondern die SPS 23 ist über entsprechende Schnittstellen - hier nicht dargestellt - mit dem Internet oder Intranet verbunden. Dies bedeutet, die SPS 23 ist Teil eines Netzwerks über welches oder von welchem die SPS 23 Informationen, Instruktionen, Programmierungen etc. erhalten kann. Zum Beispiel kann die SPS 23 über eine Verbindung zu einem sich im Intranet oder Internet befindlichen Computer Informationen über dem Prozess zugeführte Materialien bekommen, so dass beispielsweise durch die Kenntnis deren Anzahl oder Beschaffenheit der Prozess optimal gesteuert werden kann. Es ist auch denkbar, dass die SPS 23 durch einen Zugriff aus dem Intranet oder Internet von einem Anwender gesteuert wird. So kann beispielsweise ein Anwender mit Hilfe eines Computers, auch Leitrechner genannt, auf die SPS 23 zugreifen und deren Anwenderprogrammierung überprüfen, ändern, oder korrigieren. Dementsprechend ist der Zugriff auf die SPS 23 von einer oder mehreren Fernwarten oder Leitstellen möglich. Die Leitrechner können gegebenenfalls Visualisierungseinrichtungen zur Darstellung von Prozessabläufen haben.

Zur Steuerung des Prozesses der Automatisierungsanlage ist die SPS 23 mit Automatisierungsgeräten verbunden. Um den Verdrahtungsaufwand gering zu halten werden für diese Verbindungen Bussysteme verwendet. In dem in Figur 6 gezeigten Ausführungsbeispiel ist die SPS 23 mittels eines übergeordneten Busses 24, der in dem hier gezeigten Ausführungsbeispiel ein Feldbus sein kann, mit einem Lokalbusmaster 26 eines untergeordneten Lokalbussystems verbunden. An den übergeordneten Bus 24 können aber nicht nur wie in dem hier gezeigten Ausführungsbeispiel ein Lokalbusmaster 26 eines Lokalbusses angeschlossen werden, sondern auch andere beliebige Teilnehmer - hier nicht gezeigt -, die zur Kommunikation mit der SPS 23 ausgestaltet sind.

Der übergeordnete Bus 24 ist in dem hier gezeigten Ausführungsbeispiel mit dem Lokalbusmaster 26 verbunden. Hierzu weist der Lokalbusmaster 26 eine erste Schnittstelle 25 auf, die derart ausgelegt ist, dass diese mit dem übergeordneten Bus 24 verbunden werden kann. Die Schnittstelle 25 kann hierzu beispielsweise eine Aufnahme in Form einer Buchse aufweisen und der übergeordnete Bus 24 kann einen Stecker aufweisen, der von der Buchse aufgenommen werden kann. Dabei können der Stecker und die Buchse zum Beispiel ein Modularstecker und eine Modularbuchse sein, d.h. jede Ader des übergeordneten Busses 24 wird mit einer Verbindung in der Modularbuchse elektrisch oder optisch verbunden. Dem Fachmann sind aber auch andere Möglichkeiten bekannt, wie eine Schnittstelle 25 auszulegen ist, so dass der Lokalbusmaster 26 elektrisch oder optisch mit dem übergeordneten Bus 24 verbunden werden kann. Dem Fachmann sind dabei, Schraub-, Dreh-, Klick- oder Steckverbindungen bekannt, mit deren Hilfe sich eine elektrische oder optische Verbindung herstellen lassen kann. Dabei wird zumeist ein männlicher Stecker von einem weiblichen Gegenstück aufgenommen. Diese Aufnahme stellt zumeist nicht nur die elektrische oder optische Verbindung her, sondern sorgt auch dafür, dass die beiden Teile mechanisch gekoppelt werden und nur mit Aufwendung einer bestimmten Kraft wieder voneinander gelöst werden können. Es ist aber auch denkbar, dass der übergeordnete Bus 24 fest mit der Schnittstelle 25 verdrahtet ist.

Der Lokalbusmaster 26 in dem hier gezeigten Ausführungsbeispiel weist eine weitere zweite Schnittstelle auf, um den Lokalbusmaster 26 mit dem Lokalbus zu verbinden, wobei der Lokalbus in dem hier gezeigten Ausführungsbeispiel als ein Ringbus 28 ausgestaltet ist. In diesem Fall teilt sich die zweite Schnittstelle in einen ersten Teil 27a und einen zweiten Teil 27b auf. Der erste Teil 27a der zweiten Schnittstelle stellt die Abwärtsverbindung im Ringbus 28 her und der zweite Teil 27b der zweiten Schnittstelle stellt die Aufwärtsverbindung im Ringbus 28 her.

Der Ringbus 28, dessen Datensenderichtung mit Pfeilen in dem in Figur 6 gezeigten Ausführungsbespiel gezeigt ist, weist in dem hier gezeigten Ausführungsbeispiel mehrere Datenbusteilnehmer 29a, 29b, ..., 29n auf. Diese Datenbusteilnehmer 29a, 29b, ..., 29n weisen in dem hier gezeigten Ausführungsbeispiel jeweils eine Schnittstelle 30 auf, um Daten von einem vorgelagerten oder vorangehenden Datenbusteilnehmer 29a, 29b, ..., 29n zu empfangen. Im Fall von Datenbusteilnehmer 29a, empfängt dieser über die Schnittstelle 30 Daten von dem vorgelagerten Lokalbusmaster 26. Des Weiteren weisen die Datenbusteilnehmer 29a, 29b, ..., 29n in dem hier gezeigten Ausführungsbeispiel jeweils eine Schnittstelle 31 auf, um Daten an einen nachgelagerten oder nachfolgenden Datenbusteilnehmer 29a, 29b, ..., 29n weiterzuleiten. In Fall von Datenbusteilnehmer 29a sendet dieser Daten an den nachgelagerten Datenbusteilnehmer 29b über die Schnittstelle 31. Die Schnittstellen 30 und 31 dienen dabei zum Propagieren von Daten in Abwärtsrichtung des Ringbusses 28, d.h. von dem Lokalbusmaster 26 weg. Des Weiteren weisen die Datenbusteilnehmer 29a, 29b, ..., 29n in diesem Ausführungsbeispiel auch Schnittstellen 32 und 33 auf, zum Propagieren von Daten in Aufwärtsrichtung des Ringbusses 28, d.h. zum Lokalbusmaster 26 hin. Im Fall des Datenbusteilnehmers 29a ist Schnittstelle 32 dabei dazu ausgelegt, Daten von dem nachgelagerten oder nachfolgenden Datenbusteilnehmer 29b zu empfangen und Schnittstelle 33 ist dazu ausgelegt, Daten an den vorgelagerten oder vorangehenden Datenbusteilnehmer, hier den Lokalbusmaster 26, weiterzuleiten. Es kann also auch gesagt werden, dass die Schnittstellen 31 und 33 Senderschnittstellen sind, wohingegen die Schnittstellen 30 und 31 Empfängerschnittstellen sind.

In dem hier gezeigten Ausführungsbeispiel werden die Verbindungen der Schnittstellen und der SPS 23 beziehungsweise den Datenbusteilnehmern 29a, 29b, ..., 29n mit Hilfe von Kabeln oder Leiterplatten und/oder zur direkten oder indirekten Kontaktierung mittels elektrischen Kontakten realisiert. Eine andere Alternative ist, dass die einzelnen Verbindungen kabellos hergestellt werden, und die Schnittstellen die notwendigen Umsetzungen auf die verwendeten Funkstandards bereitstellen.

Auch wenn der Lokalbusmaster 26 und die einzelnen Datenbusteilnehmer 29a, 29b, ..., 29n in dem hier gezeigten Ausführungsbeispiel voneinander beabstandet gezeigt sind, der Lokalbusmaster 26 also dezentral angeordnet ist von den Datenbusteilnehmern 29a, 29b, ..., 29n, ist dem Fachmann bewusst, dass die Datenbusteilnehmer 29a, 29b, ..., 29n und der Lokalbusmaster 26 - der auch ein Datenbusteilnehmer des Ringbusses 28 darstellt - auch direkt miteinander verbunden werden können. Dabei können beispielsweise Kontakte des einen Datenbusteilnehmers in entsprechende Aufnahmen oder Aufnahmekontakte eines direkt benachbarten Datenbusteilnehmers greifen, um so eine elektrische Verbindung zwischen den Datenbusteilnehmern herzustellen, damit Daten in Abwärts- und Aufwärtsrichtung gesendet werden können. Beispielsweise können die Datenbusteilnehmer 29a, 29b,...,29n an der dem Master abgewandten Seite Aufnahmen und an der dem Master zugewandten Seite Kontakte aufweisen. Werden die Datenbusteilnehmer 29a, 29b,...,29n dann entsprechend aneinandergereiht, so greifen die Kontakte des einen Datenbusteilnehmers 29a, 29b, ..., 29n jeweils in die Aufnahmen des anderen Datenbusteilnehmers 29a, 29b, ..., 29n ein und es kann eine elektrische Verbindung erzeugt werden. Der Lokalbusmaster 26 weist dann entsprechend Kontakte an der Seite auf, die in die Aufnahmen des ersten Datenbusteilnehmers 29a greifen, um so zwischen den Schnittstellen 27a und 30 beziehungsweise den Schnittstellen 27b und 33 eine elektrische Verbindung zu erzeugen. Dem Fachmann sind aber auch noch andere Möglichkeiten, z.B. Druckkontakte, Messer- und Gabelkontakte bekannt, wie zwei direkt aneinander angeordnete Datenbusteilnehmer 29a, 29b, ..., 29n eine elektrische oder auch optische Verbindung mittels entsprechender Komponenten herstellen können.

Im Falle dessen, dass die Datenbusteilnehmer 29a, 29b, ..., 29n und der Lokalbusmaster 26 direkt miteinander verbunden werden sollen, können diese auch mechanische Aufnahmen oder mechanische Befestigungsmittel aufweisen, mit denen die einzelnen Datenbusteilnehmer 29a, 29b, ..., 29n und der Lokalbusmaster 26 miteinander verbunden werden können. Hierbei kann zum Beispiel ein Datenbusteilnehmer 29a, 29b, ..., 29n an einer Seite einen Vorsprung aufweisen und an der anderen Seite eine Hinterschneidung aufweisen. Werden die Datenbusteilnehmer 29a, 29b, ..., 29n dann aneinandergereiht, so greift ein Vorsprung in eine Hinterschneidung des anderen Datenbusteilnehmers 29a, 29b, ..., 29n ein, so dass eine mechanische Kopplung entsteht. Zur einfachen Aneinanderreihung der Datenbusteilnehmer 29a, 29b, ..., 29n können diese auch auf einer gemeinsamen Aufnahme, zum Beispiel einer Hutschiene angeordnet werden. Zur Befestigung auf der Hutschiene können die Datenbusteilnehmer 29a, 29b, ..., 29n entsprechende Befestigungsmittel aufweisen. Alternativ oder zusätzlich können die Datenbusteilnehmer 29a, 29b, ..., 29n auch beispielsweise lösbar verbindbare Befestigungsmittel aufweisen, mit denen die Datenbusteilnehmer 29a, 29b, ..., 29n entweder an der Hutschiene oder an einer anderen Aufnahme befestigt werden können. Dazu kann das lösbar verbindbare Befestigungsmittel austauschbar sein und ein entsprechendes Befestigungsmittel für die gewünschte Aufnahme kann mit den Datenbusteilnehmern 29a, 29b, ..., 29n verbunden werden, so dass diese an der gewünschten Aufnahme befestigt werden können.

Des Weiteren weisen die Datenbusteilnehmer 29a, 29b, ..., 29n in dem in Figur 6 gezeigten Ausführungsbeispiel auch eine Verarbeitungseinheit 36 auf. Diese Verarbeitungseinheit 36 kann eine arithmetische-logische Einheit sein oder eine andere Art von Rechenwerk sein mit dessen Hilfe Daten verarbeitet werden können. Die Verarbeitungseinheit 36 ist vorzugsweise ein integraler Bestandteil des Datenbusteilnehmers 29a, 29b, ..., 29n, um eine besonders schnelle und zeitlich synchronisierte Bearbeitung der Daten sicherzustellen.

Die Verarbeitungseinheit 36 kann auch als Gesamtschaltung des Datenbusteilnehmers bezeichnet werden. D.h. die Verarbeitungseinheit 36 empfängt Daten über die Eingänge 30 und 32 und gibt Daten auf den Ausgängen 31 und 33 aus. Des Weiteren kann die Verarbeitungseinheit 36 Daten von den Ein-/und Ausgängen 34 und 35 empfangen beziehungsweise ausgeben. Weiterhin hat die Verarbeitungseinheit 36 Zugriff auf einen Speicher 39 des Datenbusteilnehmers 29a, 29b, ..., 29n in dem beispielsweise Daten, Prozessdaten, oder Instruktionslisten gespeichert sind.

Die Verarbeitungseinheit 36 kann dazu ausgelegt sein, empfangene Daten zu verarbeiten und Daten auszugeben. Empfangen werden können zu verarbeitende Daten entweder von einem vorgelagerten Datenbusteilnehmer oder von Eingängen 34 des Datenbusteilnehmers 29a, 29b, ..., 29n. Dabei können die Eingänge 34 des Datenbusteilnehmers 29a, 29b, ..., 29n mit Sensoren 37 verbunden sein, die zum Beispiel Messdaten, Zustandsdaten, etc. senden. Ausgegeben werden können verarbeitete Daten entweder an einen nachgelagerten Datenbusteilnehmer oder an Ausgängen 35 des Datenbusteilnehmers 29a, 29b, ..., 29n. Dabei können die Ausgänge 35 des Datenbusteilnehmers 29a, 29b, ..., 29n mit Aktoren 38 verbunden sein, die zum Beispiel mit Hilfe der an sie gerichteten Daten eine bestimmte Aktion durchführen. Wenn in Aufwärtsrichtung auch eine Verarbeitung der Daten stattfinden soll, so können Daten auch von einem nachgelagerten Datenbusteilnehmer 29a, 29b, ..., 29n empfangen werden und verarbeitete Daten an einen vorgelagerten Datenbusteilnehmer 29a, 29b, ..., 29n gesendet werden.

Einfachheitshalber sind in dem hier gezeigten Ausführungsbeispiel die Datenbusteilnehmer 29a, 29b, ..., 29n nur mit einem Eingang 34 und einem Ausgang 35 gezeigt und auch nur Datenbusteilnehmer 29b ist mit Sensor 37 und Aktor 38 verbunden. Es ist dem Fachmann aber bewusst, dass die Datenbusteilnehmer 29a, 29b, ..., 29n eine Vielzahl von Ein- und Ausgängen 34 und 35 aufweisen können, und mit einer Vielzahl von unterschiedlichen Sensoren 37 und Aktoren 38 verbunden werden können. Dabei ist das die Sensoren 37 charakterisierende Merkmal, dass die Sensoren 37 Daten aufnehmen und an den Datenbusteilnehmer 29a, 29b, ..., 29n senden, wohingegen Aktoren 38 Daten von den Datenbusteilnehmern 29a, 29b, ..., 29n empfangen und basierend auf diesen Daten eine Aktion ausführen.

Alternativ können die Schnittstellen 30, 31, 32 und 22 in einer Moduleinheit integriert sein und die Datenbusteilnehmer 7a, 7b, 7n auf diese Moduleinheit aufgesteckt werden können. Die Moduleinheiten können auch als Basiselemente des Ringbusses 28 bezeichnet werden. Die Ringbusinfrastruktur wird dabei durch die Moduleinheiten aufgebaut und die Datenbusteilnehmer 29a, 29b, ..., 29n sind auswechselbar, so dass der Ringbus 28 mit beliebigen Datenbusteilnehmern 29a, 29b, ..., 29n aufgebaut werden kann. Mit Hilfe der Moduleinheiten ist auch sichergestellt, dass auch wenn ein Datenbusteilnehmer 29a, 29b, ..., 29n entfernt wird, die Kommunikation zwischen den restlichen Datenbusteilnehmern 29a, 29b, ..., 29n nicht unterbrochen wird, weil die Kommunikation über die noch vorhandenen Moduleinheiten geschieht.

Die in diesem Ausführungsbeispiel gezeigten Datenbusteilnehmer 29a, 29b, ..., 29n werden auf Grund ihrer Ein- und Ausgänge 34, 35, die mit Sensoren 37 beziehungsweise Aktoren 38 verbunden werden können, auch häufig als E/A-Module bezeichnet. Auch wenn die Datenbusteilnehmer 29a, 29b, ..., 29n in dem hier gezeigten Ausführungsbeispiel als räumlich getrennt von den Sensoren 37 beziehungsweise Aktoren 38 dargestellt sind, so können die Sensoren 37 beziehungsweise Aktoren 38 auch in dem E/A-Modul integriert sein.

Der in dem hier gezeigten Ausführungsbeispiel gezeigte Ringbus 28 basiert auf einer sich zyklisch wiederholenden Abfolge von Datenpaketen bzw. Telegrammen oft Zyklusrahmenkommunikation genannt. Dabei werden von dem Lokalbusmaster 26 beispielsweise Zyklusrahmen generiert, in denen ein oder mehrere Datenpakete mit einem Kopfteil, einen Prozessdatenteil oder Informationsdatenteil und einen Prüfteil enthalten sind. Der Prozessdatenteil oder Informationsdatenteil des Datenpaketes kann dabei Nutz-, Steuer-, und Prozessdaten aufweisen - wie in den Figuren 1 bis 3 gezeigt. Der eine Zyklusrahmen oder die mehreren Zyklusrahmen werden von dem Lokalbusmaster 26 in Abwärtsrichtung an den ersten Datenbusteilnehmer 29a des Ringbusses 28 gesendet. Dieser empfängt einen ersten Teil eines Datenpaketes im Zyklusrahmen über die Schnittstelle 30. Ein derartiger Teil des Datenpaketes wird im Folgenden auch als Stück oder Einheit oder Symbol bezeichnet. Der Datenbusteilnehmer 29a führt dann eine Verarbeitung des Teils aus, und leitet den Teil dann an den nächsten Datenbusteilnehmer 29b über Schnittstelle 31 weiter, vorzugsweise gleichzeitig empfängt der erste Datenbusteilnehmer 29a einen zweiten Teil des Datenpaketes usw. Die Größe der Teile des Datenpaketes, also die Stückelung des Datenpaketes, hängt dabei von der Aufnahmekapazität der Datenbusteilnehmer 29a, 29b, ..., 29n ab, beispielsweise können zur Verarbeitung gleichzeitig eine feste Anzahl von Bits, beispielsweise 8 Bits des Datenpaketes am Datenbusteilnehmer 29a, 29b, ..., 29n vorliegen.

Das Datenpaket durchläuft dementsprechend einheitenweise, stückchenweise, oder Teile weise, zum Beispiel in Teilen oder Symbolen von 8 Bits, die Datenbusteilnehmer 29a, 29b, ..., 29n. Der Teil des Datenpaketes, welcher vom letzten Datenbusteilnehmer, in dem hier gezeigten Ausführungsbeispiel Datenbusteilnehmer 29n, verarbeitet worden ist, durchläuft dann in Aufwärtsrichtung den Ringbus 28, so dass die Teile ausgehend von dem letzten Datenbusteilnehmer 29n wieder in Richtung Lokalbusmaster 26 durch alle Datenbusteilnehmer 29a, 29b, ..., 29n aufwärts gesendet werden. Hierzu weist der letzte Datenbusteilnehmer 29n entweder eine schaltbare Brücke auf, die die Schnittstelle 31 mit der Schnittstelle 32 verbindet oder an den letzten Datenbusteilnehmer 27n wird eine schaltbare Brücke - hier nicht gezeigt - angeschlossen, die die Funktion übernimmt die Teile des Datenpaketes von der Schnittstelle 31 auf die Schnittstelle 32 zu leiten. Alternativ kann die Schnittstelle 32 des Datenbusteilnehmers 7n auch mit Hilfe einer Bypassleitung - hier nicht gezeigt - direkt mit der Schnittstelle 27b des Lokalbusmasters 26 verbunden werden.

In der Aufwärtsrichtung können die Datenpakete des Zyklusrahmens, wie in dem hier gezeigten Ausführungsbeispiel durch die einzelnen Datenbusteilnehmer 29a, 29b, ..., 29n zurück an den Lokalbusmaster 26 geschleift werden, ohne dass eine weitere Verarbeitung stattfindet. Es ist aber auch denkbar, dass in der Aufwärtsrichtung erneut eine Verarbeitung der Datenpakete des Zyklusrahmens stattfindet, so dass die Datenpakete des Zyklusrahmens zweimal verarbeitet werden können, einmal auf der Abwärtsrichtung zum letzten Datenbusteilnehmer 29n und einmal in Aufwärtsrichtung zum Lokalbusmaster 26. Beispielsweise kann in Aufwärtsrichtung eine Verarbeitung durch Signalauffrischung und/oder Phasenschiebung erfolgen.

Die im Zyklusrahmen enthaltenen Datenpakete können die eingebetteten CRC-Werte, wie in den Figuren 1 bis 3 gezeigt aufweisen. Dabei können die CRC-Werte von dem Lokalbusmaster 26 beim Erzeugen des Zyklusrahmens in die Datenpakete eingefügt werden und ermöglichen auf der einen Seite dem Lokalbusmaster 26 in Aufwärtsrichtung zu erkennen, ob Fehler in der Datenübertragung eines Datenpaketes im Zyklusrahmen stattgefunden haben, andererseits erlauben diese CRC-Werte auch den Datenbusteilnehmern 29a, 29b, ..., 29n jeweils immer nur einen Teil der Datenpakete zu überprüfen, nämlich den Teil über den der CRC-Wert gebildet wurde anstelle dessen, dass erst das ganze Datenpaket vorliegen muss. Dies ist gerade bei der beschriebenen symbolweisen Sendung des Datenpaketes im Zyklusrahmen von Vorteil.

### Bezugszeichenliste

- 1: Datenpaket
- 2: Codewort
- 3: Steuerdaten
- 4: Nutzdaten
- 5: CRC-Wert
- 6a, b: CRC-Werte
- 7 bis 22: Verfahrensschritte
- 23: speicherprogrammierbare Steuerung (SPS)
- 24: übergeordneter Bus
- 25: erste Schnittstelle
- 26: Lokalbusmaster
- 27a,b: zweite Schnittstelle
- 28: Ringbus
- 29a, b, n: Datenbusteilnehmer
- 30: erste Abwärtsdatenschnittstelle
- 31: zweite Abwärtsdatenschnittstelle
- 32: erste Aufwärtsdatenschnittstelle
- 33: zweite Aufwärtsdatenschnittstelle
- 34,35: Ein-/Ausgänge
- 36: Verarbeitungseinheit
- 37: Sensor
- 38: Aktor
- 39: Speicher

## Patentansprüche

1. Ein Verfahren zur Bildung eines zu übertragenden Datenpaketes (1) mit Daten (4) und zumindest einem Wert zur zyklischen Redundanzprüfung, CRC-Wert (5, 6), wobei der CRC-Wert (5, 6) mit Hilfe von zumindest einem vorherbestimmten Polynom auf der Grundlage zumindest eines Teils der Daten (4) gebildet wird, das Verfahren weist auf:
- Initialisieren (7) eines Zählerwertes;
- Abzählen (8) von Einheiten von Daten (4), wobei für jede Einheit von Daten (4) der Zählerwert geändert wird;
- Bilden eines CRC-Wertes (5, 6) über die Einheiten von Daten (4), die abgezählt wurden wenn der Zählerwert einen Referenzwert erreicht hat oder alle Einheiten von Daten (4) in dem Datenpaket (1) bereits abgezählt wurden; und
- Einfügen (12, 14) des gebildeten CRC-Wertes (5, 6) in das Datenpaket (1), jeweils unmittelbar angrenzend an die Einheiten von Daten (4) auf deren Grundlage der CRC-Wert (5, 6) gebildet wurde.

2. Das Verfahren gemäß einem der vorhergehenden Ansprüche, wobei eine Einheit von Daten (4) eine feste Anzahl von Bits, insbesondere ein Byte ist.

3. Das Verfahren gemäß einem der vorhergehenden Ansprüche, wobei der Zählerwert beim Initialisieren auf einen vorbestimmten Binärwert gesetzt wird und wobei beim Abzählen (8) der Einheiten von Daten (4) der Zählerwert dekrementiert wird und der Referenzwert ausschließlich Nullwerte aufweist, die mit den niedrigstwertigen Positionen des Zählerwertes verglichen werden.

4. Das Verfahren gemäß einem der vorhergehenden Ansprüche, wobei zumindest zwei CRC-Werte (5, 6) mit Hilfe des gleichen Polynoms gebildet werden.

5. Das Verfahren nach einem der vorhergehenden Ansprüche, wobei der CRC-Wert (5, 6) mit Hilfe eines Castagnoli-Polynoms gebildet wird.

6. Das Verfahren gemäß einem der vorhergehenden Ansprüche, wobei die Daten (4) Nutzdaten und/oder Kopfdaten aufweisen.

7. Das Verfahren gemäß einem der vorhergehenden Ansprüche, wobei das Datenpaket (1) in einem Zyklusrahmen enthalten ist.

8. Eine Vorrichtung zur Bildung eines zu übertragenden Datenpaketes (1) mit Daten (4) und zumindest einem Wert zur zyklischen Redundanzprüfung, CRC-Wert (5, 6), wobei der CRC-Wert (5, 6) mit Hilfe von zumindest einem vorherbestimmten Polynom auf der Grundlage zumindest eines Teils der Daten gebildet wird, die Vorrichtung weist auf:
- ein Mittel zum Initialisieren eines Zählerwertes;
- ein Mittel zum Abzählen von Einheiten von Daten (4), wobei das Mittel angepasst ist, den Zählerwert zu ändern basierend auf den abgezählten Einheiten von Daten (4);
- ein Mittel zum Bilden eines CRC-Wertes (5, 6) über die abgezählten Einheiten von Daten (4), wenn der Zählerwert einen Referenzwert erreicht hat oder alle Einheiten von Daten (4) in dem Datenpaket (1) bereits abgezählt wurden; und
- ein Mittel zum Einfügen des gebildeten CRC-Wertes (5, 6) in das Datenpaket (1), jeweils unmittelbar angrenzend an die Einheiten von Daten (4) auf deren Grundlage der CRC-Wert (5, 6) gebildet wurde.

9. Ein Verfahren zur Überprüfung eines empfangenen Datenpaketes (1) mit Daten (4) und zumindest einem Wert zur zyklischen Redundanzprüfung, CRC-Wert (5, 6),
wobei ein erster CRC-Wert (5, 6) mit Hilfe von zumindest einem vorherbestimmten Polynom auf der Grundlage zumindest eines ersten Teils der Daten (4) gebildet wurden,
wobei ein zweiter CRC-Wert (5, 6) mit Hilfe von dem vorherbestimmten Polynom auf der Grundlage zumindest eines zweiten Teils der Daten (4) gebildet wurde, das Verfahren weist auf:
- Initialisieren (15) eines Zählerwertes;
- Abzählen (16) von Einheiten des ersten Teils von Daten (4) von dem empfangenen Datenpaket (1), wobei für jede Einheit von Daten (4) der Zählerwert geändert wird;
- Erkennen (19, 21) des ersten CRC-Wertes (5, 6) in den Daten (4), wenn der Zählerwert einen Referenzwert erreicht,
- Erkennen (19, 21) des zweiten CRC-Wertes (5, 6) in den Daten (4), wenn alle Einheiten von Daten (4) in dem Datenpaket (1) bereits abgezählt wurden; und
- Überprüfen (20, 22) der erkannten CRC-Werte (5, 6).

10. Das Verfahren nach Anspruch 9, wobei das Datenpaket (1) fehlerfrei empfangen wurde, wenn alle Überprüfungen (20, 21) der CRC-Werte (5, 6) keine Fehler aufzeigen.

11. Das Verfahren nach einem der Ansprüche 9 und 10, wobei der Zählerwert beim Initialisieren auf einen, insbesondere von der Länge des Datenpaketes abhängigen, Binärwert gesetzt wird und wobei beim Abzählen der Einheiten von Daten (4) der Zählerwert dekrementiert wird und der Referenzwert ausschließlich Nullwerte aufweist, die mit den niedrigstwertigen Positionen des Zählerwertes verglichen werden.

12. Das Verfahren nach einem der Ansprüche 9 bis 11, wobei die Überprüfung (20, 21) der CRC-Werte (5, 6) mit Hilfe des gleichen Polynoms durchgeführt wird.

13. Das Verfahren nach einem der Ansprüche 9 bis 12, wobei das Datenpaket (1) in einem Zyklusrahmen empfangen wird.

## Claims

1. A method for generating a data packet (1) to be transmitted, the data packet (1) comprising data (4) and at least one value (5, 6) for a cyclic redundancy check, CRC, the CRC value (5, 6) being generated by ease of at least one previously determined polynomial on the basis of at least some of the data (4), the method comprising:
- initializing (7) a counter value;
- counting (8) units of data (4), wherein the counter value changes for each unit of data (4); and
- generating a CRC value (5, 6) based on the counted units of data (4), when the counter value reaches a reference value or all units of data (4) in the data packet (1) have already been counted; and
- inserting (12, 14) the generated CRC value (5, 6) into the data packet (1) immediately adjacent to the units of data (4) on which basis the CRC value (5, 6) was generated.

2. The method according to any of the preceding claims, wherein a unit of data (4) is a fixed number of bits, in particular a byte.

3. The method according to any of the preceding claims, wherein the counter value is set to a previously determined binary value at initialization, and wherein, when the units of data (4) are counted (8), the counter value is decremented and the reference value has only zero values which are compared with the least significant positions of the counter value.

4. The method according to any of the preceding claims, wherein at least two CRC values (5, 6) are generated using the same polynomial.

5. The method according to any of the preceding claims, wherein the CRC value (5, 6) is generated using a Castagnoli polynomial.

6. The method according to any of the preceding claims, wherein the data (4) comprises payload data and/or header data.

7. The method according to any of the preceding claims, wherein the data packet (1) is contained in a cycle frame.

8. An apparatus for generating a data packet (1) to be transmitted comprising data (4) and at least one value (5, 6) for a cyclic redundancy check, CRC, the CRC value (5, 6) being generated using at least one previously determined polynomial based on at least some of the data (4), the apparatus comprising:
- means for initializing a counter value;
- means for counting units of data (4), wherein the means for counting is configured to change the counter value based on the counted units of data (4); and
- means for generating a CRC value (5, 6) based on the counted units of data (4), when the counter value reaches a reference value or all units of data (4) in the data packet (1) have already been counted; and
- means for inserting the generated CRC value (5, 6) into the data packet (1) immediately adjacent to the units of data (4) on which basis the CRC value (5, 6) was generated.

9. A method for checking a received data packet (1) comprising data (4) and at least one value (5, 6) for a cyclic redundancy check, CRC, wherein a first CRC value (5, 6) being generated by ease of at least one previously determined polynomial on the basis of at least a first portion of the data (4), a second CRC value (5, 6) being generated using the previously determined polynomial based on at least a second portion of the data (4), the method comprising:
- initializing (15) a counter value;
- counting (16) units of the first portion of data (4) of the received data packet (1), a counter value changing for each unit of data (4);
- detecting (19, 21) the first CRC value (5, 6) in the data (4) when the counter value reaches a reference value;
- detecting (19, 21) the second CRC value (5, 6) in the data (4) when all the units of data (4) in the data packet (1) have already been counted; and
- checking (20, 22) the detected CRC values (5 ,6).

10. The method according to claim 9, wherein the data packet (1) was received without errors if all checks (20, 21) of the CRC values (5, 6) do not show any errors.

11. The method according to any of claims 9 and 10, wherein the counter value is set during initialization to a binary value, in particular dependent on a length of the data packet, and wherein, when the units of data (4) are counted, the counter value is decremented and the reference value only has zero values which are compared with the least significant positions of the counter value.

12. The method according to any of claims 9 to 11, wherein the checking (20, 21) of the CRC values (5, 6) is performed using the same polynomial.

13. The method according to any of claims 9 to 12, wherein the data packet (1) is received in a cycle frame.

## Revendications

1. Un procédé pour la formation d'un paquet de données (1) à transmettre avec des données (4) et au moins une valeur pour le contrôle de redondance cyclique, valeur CRC (5, 6), dans lequel la valeur CRC (5, 6) est formée à l'aide d'au moins un polynôme prédéfini sur la base d'au moins une partie des données (4), le procédé comprenant :
- l'initialisation (7) d'une valeur de compteur ;
- le comptage (8) d'unités de données (4), dans lequel pour chaque unité de données (4) la valeur de compteur est modifiée ;
- la formation d'une valeur CRC (5, 6) par l'intermédiaire des unités de données (4), qui ont été comptées lorsque la valeur de compteur a atteint une valeur de référence ou toutes les unités de données (4) dans le paquet de données (1) ont déjà été comptées ; et
- l'insertion (12, 14) dans le paquet de données (1) de la valeur CRC (5, 6) formée, de manière respectivement directement adjacente aux unités de données (4) sur la base desquelles la valeur CRC (5, 6) a été formée.

2. Le procédé selon l'une des revendications précédentes, dans lequel une unité de données (4) est un nombre fixe de bits, en particulier un octet.

3. Le procédé selon l'une des revendications précédentes, dans lequel la valeur de compteur lors de l'initialisation est établie à une valeur binaire prédéfinie et dans lequel lors du comptage (8) des unités de données (4) la valeur de compteur est décrémentée et la valeur de référence présente exclusivement des valeurs nulles, qui sont comparées aux positions à valeur la plus faible des valeurs de compteur.

4. Le procédé selon l'une des revendications précédentes, dans lequel au moins deux valeurs CRC (5, 6) sont formées à l'aide du même polynôme.

5. Le procédé selon l'une des revendications précédentes, dans lequel la valeur CRC (5, 6) est formée à l'aide d'un polynôme de Castagnoli.

6. Le procédé selon l'une des revendications précédentes, dans lequel les données (4) présentent des données à exploiter et/ou des données d'en-tête.

7. Le procédé selon l'une des revendications précédentes, dans lequel le paquet de données (1) est contenu dans une trame de cycle.

8. Un dispositif pour la formation d'un paquet de données (1) à transmettre avec des données (4) et au moins une valeur pour le contrôle de redondance cyclique, valeur CRC (5, 6), dans lequel la valeur CRC (5, 6) est formée à l'aide d'au moins un polynôme prédéfini sur la base d'au moins une partie des données, le dispositif comprenant :
- un moyen pour initialiser une valeur de compteur ;
- un moyen pour compter des unités de données (4), dans lequel le moyen est adapté pour modifier la valeur de compteur en se basant sur les unités de données (4) comptées ;
- un moyen pour former une valeur CRC (5, 6) par l'intermédiaire des unités de données (4) comptées, lorsque la valeur de compteur a atteint une valeur de référence ou que toutes les unités de données (4) ont déjà été comptées dans le paquet de données (1) ; et
- un moyen pour insérer dans le paquet de données (1)la valeur CRC (5, 6) formée, de manière respectivement directement adjacente aux unités de données (4) sur la base desquelles la valeur CRC (5, 6) a été formée.

9. Un procédé pour le contrôle d'un paquet de données (1) reçu avec des données (4) et au moins une valeur pour le contrôle de redondance cyclique, valeur CRC (5, 6),
dans lequel une première valeur CRC (5, 6) ont été formées à l'aide d'au moins un polynôme prédéfini sur la base d'au moins une première partie des données (4),
dans lequel une deuxième valeur CRC (5, 6) a été formée à l'aide du polynôme prédéfini sur la base d'au moins une deuxième partie des données (4), le procédé comprenant :
- l'initialisation (15) d'une valeur de compteur ;
- le comptage (16) d'unités de la première partie de données (4) du paquet de données (1) reçu, dans lequel pour chaque unité de données (4) la valeur de compteur est modifiée ;
- l'identification (19, 21) de la première valeur CRC (5, 6) dans les données (4), lorsque la valeur de compteur atteint une valeur de référence,
- l'identification (19, 21) de la deuxième valeur CRC (5, 6) dans les données (4), lorsque toutes les unités de données (4) ont déjà été comptées dans le paquet de données (1) ; et
- le contrôle (20, 22) des valeurs CRC (5, 6) identifiées.

10. Le procédé selon la revendication 9, dans lequel le paquet de données (1) a été reçu sans erreur lorsque tous les contrôles (20, 21) des valeurs CRC (5, 6) ne mettent en évidence aucune erreur.

11. Le procédé selon l'une des revendications 9 et 10, dans lequel la valeur de compteur lors de l'initialisation est établie à une valeur binaire, en particulier dépendant de la longueur du paquet de données, et dans lequel lors du comptage des unités de données (4) la valeur de compteur est décrémentée et la valeur de référence présente exclusivement des valeurs nulles, qui sont comparées aux positions à valeur la plus basse de la valeur de compteur.

12. Le procédé selon l'une des revendications précédentes 9 à 11, dans lequel le contrôle (20, 21) des valeurs CRC (5, 6) est mis en oeuvre à l'aide du même polynôme.

13. Le procédé selon l'une des revendications précédentes 9 à 12, dans lequel le paquet de données (1) est reçu dans une trame de cycle.
